(19) **Europäisches Patentamt / European Patent Office / Office européen des brevets**

(11) **EP 2 796 683 A1**

(12) # EUROPEAN PATENT APPLICATION
published in accordance with Art. 153(4) EPC

(43) Date of publication:
**29.10.2014 Bulletin 2014/44**

(51) Int Cl.:
***F01N 3/20*** (2006.01)

(21) Application number: **11878239.0**

(86) International application number:
**PCT/JP2011/079528**

(22) Date of filing: **20.12.2011**

(87) International publication number:
**WO 2013/094021 (27.06.2013 Gazette 2013/26)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(71) Applicant: **Toyota Jidosha Kabushiki Kaisha Toyota-shi, Aichi 471-8571 (JP)**

(72) Inventor: **YOSHIOKA, Mamoru**
**Toyota-shi**
**Aichi 471-8571 (JP)**

(74) Representative: **Intès, Didier Gérard André et al**
**Cabinet Beau de Loménie**
**158, rue de l'Université**
**75340 Paris Cedex 07 (FR)**

(54) **FAILURE DETECTION APPARATUS FOR AN ELECTRICALLY HEATED CATALYST**

(57) The present invention is intended to detect insulation failure of an EHC. In the invention, a heat generation element of the EHC is electrically insulated by an insulating member. Then, a determination as to whether insulation failure has occured is made based on an insulation resistance value of the insulating member at the time when an amount of water absorption in the insulating member is smaller than a predetermined amount of water absorption and when an amount of PM deposition in the insulating member is smaller than a predetermined amount of PM deposition, a change in the insulation resistance value of the insulating member at the time when the amount of water absorption in the insulating member decreases from an amount equal to or larger than the predetermined amount of water absorption to an amount smaller than the predetermined amount of water absorption, and a change in the insulation resistance value of the insulating member at the time when the amount of PM deposition in the insulating member decreases from an amount equal to or larger than the predetermined amount of PM deposition to an amount smaller than the predetermined amount of PM deposition.

Fig. 12

**Description**

[TECHNICAL FIELD]

The present invention relates to a failure detection apparatus for an electrically heated catalyst.

[BACKGROUND ART]

In the past, as an exhaust gas purification catalyst arranged in an exhaust passage of an internal combustion engine, there has been developed an electrically heated catalyst (hereinafter, may also be referred to as an EHC) in which a catalyst is heated by means of a heat generation element which generates heat by electrical energization thereof.
In Patent Document 1, there is disclosed a technique in which in an electrically heated catalyst with electrical insulation having a carrier holding part which serves to hold a catalyst carrier, electrical energization is prohibited in cases where it has been determined that the insulation resistance of the carrier holding part has been reduced to equal to or less than a predetermined resistance value. In addition, in Patent Document 1, there is also disclosed a technology in which in cases where the temperature of the carrier holding part is equal to or larger than a predetermined temperature, when an amount of moisture absorbed by the carrier holding part is equal to or larger than a predetermined amount, or when an amount of carbon deposited on the carrier holding part is equal to or larger than a predetermined amount, a determination is made that the insulation resistance of the carrier holding part has been reduced to equal to or less than the predetermined resistance value.
In Patent Document 2, there is disclosed a technique in which it is determined whether condensed water exists in an exhaust gas, by making a comparison between temperatures detected by a first temperature sensor to which condensed water is liable to adhere, and by a second temperature sensor to which condensed water does not adhere, respectively, which are arranged in the exhaust passage.
In Patent Document 3, there is disclosed a technique in which an amount of deposition of particulate matter is calculated based on the degree of temperature rise of an oxidation catalyst at the time when the oxidation catalyst arranged in an exhaust passage is heated.
In Patent Document 4, there is disclosed a technique in which failure of a PM sensor is determined based on a change in the electrostatic capacitance of sensor electrode parts of the PM sensor which is generated when condensed water generated in an exhaust passage immediately after starting of an internal combustion engine adheres to the sensor electrode parts.
In Patent Document 5, there is disclosed a technique in which an electrically insulating material is arranged in an exhaust passage at the downstream side of a particulate filter, and further, a plurality of electrodes are formed on the electrically insulating material at a distance from each other, wherein when an index correlated with an electric resistance value between each pair of the plurality of the electrodes is smaller than a predetermined reference, a determination is made that the particulate filter is in failure.

[Prior Art Documents]

[PATENT DOCUMENTS]

Patent Document 1: International Publication No. 2011-114451
Patent Document 2: Japanese Patent Laid-Open Publication No. 2010-127268
Patent Document 3: Japanese Patent Laid-Open Publication No. 2007-304068
Patent Document 4: Japanese Patent Laid-Open Publication No. 2010-275917
Patent Document 5: Japanese Patent Laid-Open Publication No. 2009-144577

[SUMMARY OF THE INVENTION]

[PROBLEMS TO BE SOLVED BY THE INVENTION]

In an EHC, in order to electrically insulate a heat generation element which generates heat by being electrically energized, an insulating member is provided. However, even with such a construction, there may occur insulation failure in the EHC in which an insulation function to electrically insulate the heat generation element is reduced beyond an allowable range.
The present invention has been made in view of the problems as referred to above, and has for its object to detect insulation failure in an EHC.

[MEANS FOR SOLVING THE PROBLEMS]

A failure detection apparatus for an electrically heated catalyst according to the present invention resides in a failure detection apparatus to detect failure of the electrically heated catalyst which is arranged in an exhaust passage of an internal combustion engine, and which includes:

a heat generation element that generates heat by electrical energization and heats the catalyst by the generation of heat; and

an insulating member that electrically insulates said heat generation element;

wherein a determination unit is provided that determines whether insulation failure has occurred, by making a distinction from a reduction in an insulation resistance value of said insulating member resulting from condensed water absorbed in said insulating member or resulting from particulate matter deposited on said insulating member, based on the insulation resistance value of said insulating member at the time when an amount of water absorption in said insulating member is smaller than a predetermined amount of water absorption and when an amount of deposition of particulate matter in said insulating member is smaller than a predetermined amount of PM deposition, a change in the insulation resistance value of said insulating member at the time when the amount of water absorption in said insulating member decreases from an amount equal to or larger than said predetermined amount of water absorption to an amount smaller than said predetermined amount of water absorption, and a change in the insulation resistance value of said insulating member at the time when the amount of deposition of particulate matter in said insulating member decreases from an amount equal to or larger than said predetermined amount of PM deposition to an amount smaller than said predetermined amount of PM deposition.

When the condensed water generated in the exhaust passage is absorbed into the insulating member, the amount of water absorption in the insulating member will increase. However, when the condensed water evaporates due to a rise in the temperature of the electrically heated catalyst (EHC), the amount of the condensed water will decrease. On the other hand, when the particulate matter included in the exhaust gas adheres to the insulating member, the amount of deposition of the particulate matter in the insulating member will increase. However, if the particulate matter is removed by carrying out PM removal processing in which the particulate matter deposited on the insulating member is removed by oxidation, the amount of the particulate matter will be decreased.

In the EHC, even if insulation failure has not occurred, when the amount of water absorption in the insulating member or the amount of deposition of particulate matter in the insulating member increases, the insulation resistance value of the insulating member will be decreased. However, in cases where the insulation resistance value of the insulating member is decreased resulting from the condensed water which has been absorbed into the insulating member, if the amount of water absorption therein decreases, the insulation resistance value of the insulating member will be restored. Also, in cases where the insulation resistance value of the insulating member is decreased resulting from the particulate matter deposited on the insulating member, if the amount of deposition of particulate matter decreases, the insulation resistance value of the insulating member will be restored. On the other hand, in cases where the insulation resistance value of the insulating member has been decreased due to an occurrence of insulation failure, the insulation resistance value will not be restored.

Here, the predetermined amount of water absorption and the predetermined amount of PM deposition are set as such values that if insulation failure does not occur, if the amount of water absorption in the insulating member is smaller than the predetermined amount of water absorption and the amount of deposition of particulate matter in the insulating member is smaller than the predetermined amount of PM deposition, the insulation resistance value of the insulating member will be a normal value.

According to the present invention, it is possible to detect the insulation failure of the EHC by making a distinction from the reduction in the insulation resistance value of the insulating member resulting from the condensed water or particulate matter.

In the present invention, the determination unit may make a determination that insulation failure has occurred, in cases where the insulation resistance value of the insulating member is equal to or less than the predetermined resistance value, at the time when the amount of water absorption in the insulating member is smaller than the predetermined amount of water absorption and when the amount of deposition of particulate matter in the insulating member is smaller than the predetermined amount of PM deposition. Here, the predetermined resistance value is a value which is lower than an insulation resistance value of the insulating member in the case of an occurrence of insulation failure of the EHC, i.e., a value which is lower than a lower limit value of a permissible insulation resistance value.

Further, in cases where the insulation resistance value of the insulating member is equal to or less than the predetermined resistance value when the amount of water absorption in the insulating member is equal to or larger than the predetermined amount of water absorption, but where the insulation resistance value of the insulating member goes up above the predetermined resistance value when the amount of water absorption in the insulating member decreases below the predetermined amount of water absorption, it can be judged that a cause of the reduction in the insulation resistance value of the insulating member is the condensed water which has been absorbed into the insulating member. For that reason, in such a case, the determination unit may make a determination that insulation failure has not occurred.

In addition, in cases where the insulation resistance value of the insulating member is equal to or less than the predetermined resistance value when the amount of deposition of particulate matter in the insulating member is equal to or larger than the predetermined amount of PM deposition, but where the insulation resistance value of the insulating member goes up above the predetermined resistance value when the amount of deposition of particulate matter in the insulating member decreases below said predetermined amount of PM deposition, it can be judged that a cause of the reduction in the insulation resistance value of the insulating member is the particulate matter which has deposited on the insulating member. For that reason, in such a case, the determination unit may make a determination that insulation failure has not occurred.

Moreover, when the amount of water absorption in the insulating member is equal to or larger than the predetermined amount of water absorption, even if the insulation resistance value of the insulating member is lower than the normal value, it is difficult to distinguish whether the cause for that is the condensed water absorbed into the insulating member or insulation failure. In addition, when the amount of deposition of particulate matter in the insulating member is equal to or larger than the predetermined amount of PM deposition, even if the insulation resistance value of the insulating member is lower than the normal value, it is difficult to distinguish whether the cause for that is the particulate matter having deposited on the insulating member or insulation failure.

Accordingly, in the present invention, in cases where the insulation resistance value of the insulating member is equal to or less than the predetermined resistance value at the time when the amount of water absorption in the insulating member is equal to or larger than the predetermined amount of water absorption, the determination unit may suspend the determination of whether insulation failure has occurred until the amount of water absorption in the insulating member decreases below the predetermined amount of water absorption. In addition, in cases where the insulation resistance value of the insulating member is equal to or less than the predetermined resistance value at the time when the amount of deposition of particulate matter in the insulating member is equal to or larger than the predetermined amount of PM deposition, the determination unit may suspend the determination of whether insulation failure has occurred until the amount of deposition of particulate matter in the insulating member decreases below the predetermined amount of PM deposition.

Further, as the temperature of the EHC rises, the temperature of the insulating member also rises. Then, when the temperature of the insulating member rises, even at normal time, the insulation resistance value of the insulating member will decrease.

Accordingly, the failure detection apparatus for an electrically heated catalyst according to the present invention may be further provided with a setting unit that serves to set the predetermined resistance value to a smaller value when the temperature of the EHC is high, in comparison with the case when the EHC temperature is low. According to this, it is possible to detect insulation failure of the EHC with a higher degree of accuracy.

Here, in cases where the internal combustion engine is cold started, i.e., in cases where the internal combustion engine is started in a state where the temperature of the entire EHC including the insulating member is low, the temperature of the EHC rises with the passage of time. However, the insulating member has a certain amount of heat capacity, so the temperature rise thereof is delayed. For that reason, the temperature of the insulating member is maintained to be low until a certain period of time elapses after the internal combustion engine is cold started. Therefore, during that period of time, the insulation resistance value of the insulating member is maintained without decreasing.

Accordingly, during the period of time from the cold starting of the internal combustion engine until the predetermined period of time elapses, the setting unit may maintain the predetermined resistance value to a constant or fixed value, even if the temperature of the EHC rises. Here, the predetermined period of time is a period of time for which the temperature of the insulating member is maintained to be low.

In addition, when the engine load of the internal combustion engine changes, the temperature of the exhaust gas will change, so the temperature of the EHC will change. As a result, the temperature of the insulating member will change, and hence, if the EHC is normal, the insulation resistance value of the insulating member will change. However, when insulation failure has occurred, even if the temperature of the insulating member changes, the insulation resistance value of the insulating member will not change according to that.

Accordingly, in the present invention, in cases where the insulation resistance value of the insulating member, at the time when the amount of water absorption in the insulating member is smaller than the predetermined amount of water absorption and when the amount of deposition of particulate matter in the insulating member is smaller than the predetermined amount of PM deposition, changes according to a change in the engine load of the internal combustion engine, the determination unit may make a determination that insulation failure has not occurred, but in cases where the insulation resistance value does not change according to a change in the engine load of the internal combustion engine, the determination unit may make a determination that insulation failure has occurred.

[ADVANTAGEOUS EFFECT OF THE INVENTION]

According to the present invention, insulation failure of the EHC can be detected.

[BRIEF DESCRIPTION OF THE DRAWINGS]

[Fig. 1] Fig. 1 is a view showing the schematic construction of intake and exhaust systems and an EHC of an internal combustion engine according to a first embodiment of the present invention.
[Fig. 2] Fig. 2 is a view showing the arrangement of electrodes with respect to a catalyst carrier according to the first embodiment.
[Fig. 3] Fig. 3 is a view showing the schematic construction of a measuring device according to the first embodiment.
[Fig. 4] Fig. 4 is a time chart showing a first example of changes over time of an engine rotational speed Ne, a temperature Tehc of an EHC, an amount of water absorption cwater of a mat, amounts of PM deposition cpm in an end face of the mat and in a protrusion portion of an inner pipe, and an insulation resistance value Rehc.
[Fig. 5] Fig. 5 is a time chart showing a second example of changes over time of the engine rotational speed Ne, the temperature Tehc of the EHC, the amount of water absorption cwater of the mat, amounts of PM deposition cpm in the end face of the mat and in the protrusion portion of the inner pipe, and the insulation resistance value Rehc.
[Fig. 6] Fig. 6 is a flow chart showing a calculation flow for the amount of water absorption of the mat according to the first embodiment.
[Fig. 7] Fig. 7 is a view showing the relation among a temperature Tg of an exhaust gas, an air fuel ratio A/F of an air fuel mixture, and an amount of generation kwater1 of condensed water in an exhaust pipe, according to the first embodiment.
[Fig. 8] Fig. 8 is a view showing the relation between the temperature Tehc of the EHC and an amount of evaporation kwater2 of condensed water from the mat according to the first embodiment.
[Fig. 9] Fig. 9 is a flow chart showing a calculation flow for the amount of PM deposition in the end face of the mat and in the protrusion portion of the inner pipe according to the first embodiment.
[Fig. 10] Fig. 10 is a view showing the relation between a temperature Tw of cooling water, the air fuel ratio A/F of the air fuel mixture, and an amount of emission kpm1 of particulate matter from the internal combustion engine, according to the first embodiment.
[Fig. 11] Fig. 11 is a view showing the relation between the temperature Tehc of the EHC and an amount of oxidation kpm2 of the particulate matter deposited on the end face of the mat or the protrusion portion of the inner pipe, under a state where there exists a sufficient amount of oxygen for oxidizing particulate matter, according to the first embodiment.
[Fig. 12] Fig. 12 is a flow chart showing a part of a detection flow for insulation failure according to the first embodiment.
[Fig. 13] Fig. 13 is a flow chart showing another part of the detection flow for insulation failure according to the first embodiment.
[Fig. 14] Fig. 14 is a flow chart showing another part of the detection flow for insulation failure according to the first embodiment.
[Fig. 15] Fig. 15 is a flow chart showing a setting flow for a predetermined resistance value according to a first modification of the first embodiment.
[Fig. 16] Fig. 16 is a view showing the relation between the temperature Tehc of the EHC and a predetermined resistance value Rehc0 according to the modification of the first embodiment.
[Fig. 17] Fig. 17 is a flow chart showing a setting flow for a predetermined resistance value according to a second modification of the first embodiment.
[Fig. 18] Fig. 18 is a flow chart showing a detection flow for insulation failure according to a second embodiment of the present invention.

[EMBODIMENTS FOR CARRYING OUT THE INVENTION]

Hereinafter, specific embodiments of the present invention will be described based on the attached drawings. However, the dimensions, materials, shapes, relative arrangements and so on of component parts described in the embodiments are not intended to limit the technical scope of the present invention to these alone in particular as long as there are no specific statements.

<First Embodiment>

[Schematic Construction of Intake and Exhaust Systems and EHC of Internal Combustion Engine]

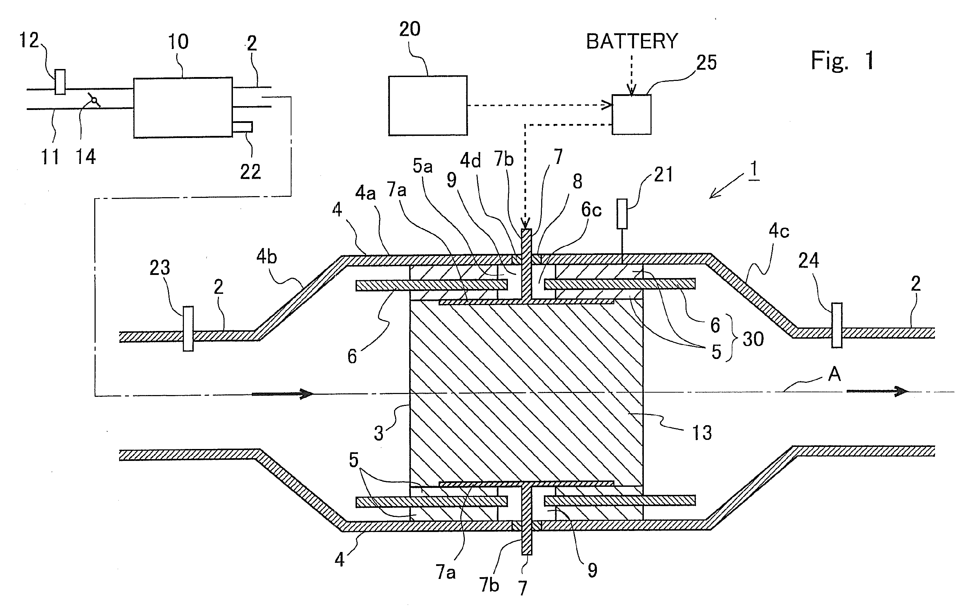

Fig. 1 is a view showing the schematic construction of intake and exhaust systems and an EHC of an internal combustion engine according to this embodiment.

The EHC 1 according to this embodiment is arranged in an exhaust pipe 2 of the internal combustion engine 10. The internal combustion engine 10 is a gasoline engine for driving a vehicle. However, note that the internal combustion engine related to the present invention is not limited to a gasoline engine, but may be a diesel engine, etc. On the internal combustion engine 10, there is mounted a water temperature sensor 22 for detecting the temperature of cooling water. In an intake pipe 11 of the internal combustion engine 10, there are arranged an air flow meter 12 and a throttle valve 14.

A first temperature sensor 23 is arranged in the exhaust pipe 2 at the upstream side of the EHC 1. A second temperature sensor 24 is arranged in the exhaust pipe 2 at the downstream side of the EHC 1. The first and second temperature sensors 23, 24 are each a sensor for detecting the temperature of an exhaust gas. Here, note that an arrow in Fig. 1 shows the direction of the flow of the exhaust gas in the exhaust pipe 2.

The EHC 1 is provided with a catalyst carrier 3, a case 4, a mat 5, an inner pipe 6, and electrodes 7. The catalyst carrier 3 is formed in the shape of a circular column, and is disposed in such a manner that a central axis thereof is in alignment with a central axis A of the exhaust pipe 2. A three-way catalyst 13 is carried or supported by the catalyst carrier 3. Here, note that a catalyst supported on the catalyst carrier 3 is not limited to the three-way catalyst, but may be an oxidation catalyst, an NOx storage reduction catalyst, or an NOx selective reduction catalyst.

The catalyst carrier 3 is formed of a material which, when electrically energized, becomes an electric resistance to generate heat. As a material for the catalyst carrier 3, there can be mentioned SiC by way of example. The catalyst carrier 3 has a plurality of passages which extend in a direction in which the exhaust gas flows (i.e., the direction of the central axis A), and which have a cross section of honeycomb shape vertical to the direction in which the exhaust gas flows. The exhaust gas flows through these passages. Here, note that the cross sectional shape of the catalyst carrier 3 in the direction orthogonal to the central axis A may also be elliptical, etc. The central axis A is a common central axis with respect to the exhaust pipe 2, the catalyst carrier 3, the inner pipe 6, and the case 4.

The catalyst carrier 3 is contained in the case 4. An electrode chamber 9 is formed inside the case 4. Here, note that the details of the electrode chamber 9 will be described later. One pair of electrodes 7 are connected to the catalyst carrier 3 through the electrode chamber 9 from left and right directions. Electricity is supplied to the electrodes 7 from a battery through an supply power control unit 25. When electricity is supplied to the electrodes 7, the catalyst carrier 3 is electrically energized. When the catalyst carrier 3 generates heat by energization thereof, the three-way catalyst 13 supported by the catalyst carrier 3 is heated, so that the activation thereof is facilitated.

The case 4 is formed of metal. As a material which forms the case 4, there can be mentioned a stainless steel material by way of example. The case 4 has a containing portion 4a which is constructed to include a curved surface parallel to the central axis A, and tapered portions 4b, 4c which serve to connect the containing portion 4a and the exhaust pipe 2 with each other at the upstream side and at the downstream side, respectively, of the containing portion 4a. The containing portion 4a has a channel cross section which is larger than that of the exhaust pipe 2, and the catalyst carrier 3, the mat 5 and the inner pipe 6 are contained in the inside of the containing portion 4a. The tapered portions 4b, 4c each take a tapered shape of which the channel cross section decreases in accordance with the increasing distance thereof from the containing portion 4a.

The mat 5 is inserted between an inner wall surface of the containing portion 4a of the case 4, and an outer peripheral surface of the catalyst carrier 3. In other words, in the inside of the case 4, the catalyst carrier 3 is supported by the mat 5. In addition, the inner pipe 6 is inserted in the mat 5. The inner pipe 6 is a tubular member with the central axis A being located as a center thereof. The mat 5 is arranged to sandwich or clamp the inner pipe 6 therein, whereby it is divided into a portion at the side of the case 4 and a portion at the side of the catalyst carrier 3 by means of the inner pipe 6.

The mat 5 is formed of an electrically insulating material. As a material which forms the mat 5, there can be mentioned, by way of example, a ceramic fiber which includes alumina as a main component. The mat 5 is wound around the outer peripheral surface of the catalyst carrier 3 and the outer peripheral surface of the inner pipe 6. Due to the insertion of the mat 5 between the catalyst carrier 3 and the case 4, it is possible to suppress electricity from flowing to the case 4 at the time when the catalyst carrier 3 is electrically energized.

The inner pipe 6 is formed of a stainless steel material. In addition, an electrically insulating layer is formed on the entire surface of the inner pipe 6. As a material which forms the electrically insulating layer, ceramic or glass can be mentioned by way of example. With the formation of the electrically insulating layer on the entire surface of the inner pipe 6, the inner pipe 6 functions as an insulating member. Here, note that the main body of the inner pipe 6 may be formed of an electrically insulating material such as alumina or the like. In addition, as shown in Fig. 1, the inner pipe 6 has a length in the direction of the central axis A longer than that of the mat 5. As a result, the inner pipe 6 has an upstream side end and a downstream side end thereof protruding from an upstream side end face and a downstream side end face of the mat 5, respectively. In the following, those portions of the inner pipe 6 which protrude from the upstream side or downstream side end faces of the mat 5 are referred to as "protrusion portions".

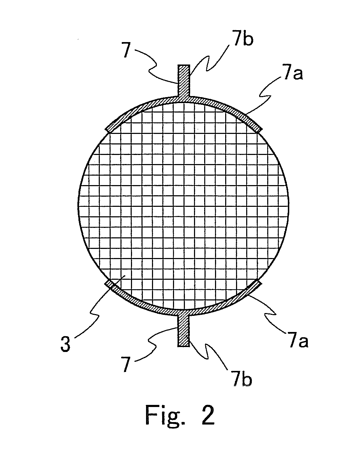

The pair of electrodes 7 are connected to the outer peripheral surface of the catalyst carrier 3. Fig. 2 is a view showing the arrangement of the electrodes 7 with respect to the catalyst carrier 3. Fig. 2 is a cross sectional view at the time of cutting the catalyst carrier 3 and the electrodes 7 in a direction crossing at right angles to an axial direction. Each electrode 7 is formed of a surface electrode 7a and a shaft electrode 7b. Each surface electrode 7a extends along the outer peripheral surface of the catalyst carrier 3 in a circumferential direction and in the axial direction. In addition, the surface electrodes 7a are arranged on the outer peripheral surface of the catalyst carrier 3 in such a manner that they are mutually opposed to each other with the catalyst carrier 3 being sandwiched therebetween. Each shaft electrode 7b has one end thereof connected to a corresponding surface electrode 7a. And, each shaft electrode 7b has the other end thereof protruded to the outside of the case 4 through the electrode chamber 9.

The case 4, the mat 5 and the inner pipe 6 have through holes 4d, 5a, 6c opened therein so as to allow the shaft electrodes 7b to pass therethrough, respectively. Then, in the case 4, the electrode chamber 9 is formed by a space which is surrounded by the circumferential surface of the through hole 5a in the mat 5. Here, note that the electrode chamber 9 may be formed over the circumferentially entire outer peripheral surface of the catalyst carrier 3, by dividing the mat 5 into an upstream side portion and a downstream side portion, which are arranged separately from each other with a space therebetween.

Electrode support members 8, which serve to support the shaft electrodes 7b, respectively, are arranged or inserted in the through holes 4d which are opened in the case 4. These electrode support members 8 are each formed of an electrically insulating material, and are fitted with no gap between the case 4 and the electrodes 7.

The shaft electrodes 7b have the other ends thereof electrically connected to the battery (not shown) through the supply power control unit 25. Electricity is supplied to the electrodes 7 from the battery. When electricity is supplied to the electrodes 7, the catalyst carrier 3 is electrically energized. When the catalyst carrier 3 generates heat by energization thereof, the three-way catalyst 13 supported by the catalyst carrier 3 is heated, so that the activation thereof is facilitated. The supply power control unit 25 serves to switch on and off the supply of electricity to the electrodes 7 (i.e., electrical energization to the EHC 1), and to adjust the electric power to be supplied thereto.

In addition, the EHC 1 is provided with a measuring device 21 for measuring an insulation resistance value of the mat 5 and the inner pipe 6. Here, note that in the following, the mat 5 and the inner pipe 6 are generally referred to as an insulating member 30.

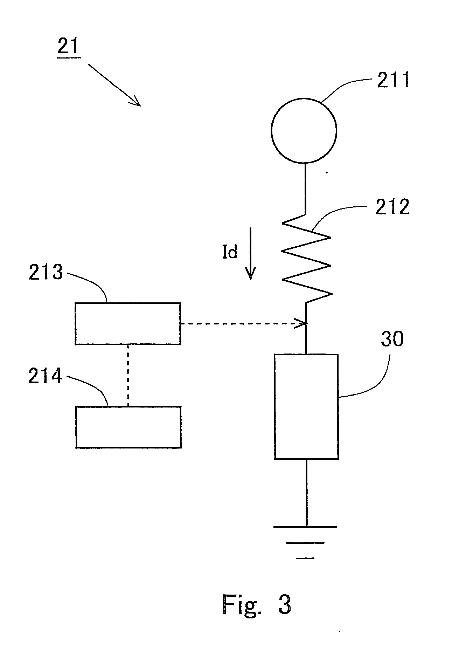

Fig. 3 is a view showing the schematic construction of the measuring device 21. The measuring device 21 is provided with a reference power supply 211, a reference resistance 212, a voltmeter 213, and a resistance value calculation circuit 214. As shown in Fig. 3, the reference resistance 212 and the insulating member 30 are connected in series to each other. And, the reference power supply 211 applies a reference voltage, which is an amplified voltage supplied from the battery, to the reference resistance 212 and the insulating member 30. The voltmeter 213 measures a voltage between the reference resistance 212 and the insulating member 30 at the time when the reference voltage is applied to the reference resistance 212 and the insulating member 30 from the reference power supply voltage 211. The resistance value calculation circuit 214 calculates the insulation resistance value of the insulating member 30 based on the voltage measured by the voltmeter 213.

Here, note that when representing the reference voltage by Vref, a resistance value (a reference resistance value) of the reference resistance 212 by Ref, an electric current flowing through the reference resistance 212 and the insulating member 30 by Id, and the voltage measured by means of the voltmeter 213 by Vehc, the insulation resistance value Rehc of the insulating member 30 is represented by the following equations (1) and (2). The resistance value calculation circuit 214 calculates the insulation resistance value of the insulating member 30 by the use of these equations (1) and (2).

$$Id = (Vref - Vehc)/ Rref ... (1)$$

$$Rehc = Vehc/ Id$$
$$= Vehc/ (Vref - Vehc) * Rref ... (2)$$

The supply power control unit 25 is electrically connected to an electronic control unit (ECU) 20 which is provided in combination with the internal combustion engine 10. Also, the throttle valve 14 and fuel injection valves (not shown) of the internal combustion engine 10 are electrically connected to the ECU 20, too. Thus, these parts are controlled by the ECU 20.

In addition, the air flow meter 12, the water temperature sensor 22, the first temperature sensor 23, the second temperature sensor 24, and the first air fuel ratio sensor 22, and the measuring device 21 are electrically connected to the ECU 20. Thus, output values (signals) of the individual sensors and a measured value of the measuring device 21 are inputted to the ECU 20.

Here, note that in this embodiment, the catalyst carrier 3 corresponds to a heat generation element according to the present invention. However, the heat generation element according to the present invention is not limited to a carrier carrying or supporting a catalyst. For example, the heat generation element may be a structural member which is arranged at the upstream side of a catalyst. Also, in this embodiment, the insulating member 30 correspond to an insulating member 30 according to the present invention. However, the insulating member according to the present invention may not necessarily be composed of the mat 5 and the inner pipe 6, but instead should just be a member which can electrically insulate the catalyst carrier 3. For example, the insulating member can also be composed of only the mat 5.

[Detection Method for Insulation Failure]

As stated above, in this embodiment, the catalyst carrier 3 to generate heat by energization is electrically insulated by the insulating member 30. However, even with such a construction, there may occur insulation failure in which an insulation function to electrically insulate the catalyst carrier 3 is reduced beyond an allowable range, due to the deterioration of the insulating member 30, etc. For that reason, in this embodiment, insulation failure is detected based on the insulation resistance value of the insulating member 30 measured by the measuring device 21.

However, even if insulation failure has not occurred, the insulation resistance value of the insulating member 30 may be decreased resulting from the condensed water absorbed in the mat 5 or the particulate matter (hereinafter referred to as PM) deposited on the end face of the mat 5 and the protrusion portion of the inner pipe 6.

More specifically, in the exhaust pipe 2 or in the case 4, there may be generated condensed water due to condensation of the moisture contained in the exhaust gas. When this condensed water arrives at the mat 5 while flowing along an inner wall surface of the case 4, a part of the condensed water is absorbed into the mat. Then, when the amount of the condensed water thus absorbed in the mat 5 increases, the condensed water comes into the electrode chamber 9, too. As a result, the case 4, the electrodes 7 and the catalyst carrier 3 become electrically conductive to one another through the condensed water, whereby the insulation resistance value of the insulating member 30 decreases. Here, note that with a construction in which the inner pipe 6 is not provided, there is a fear that the case 4, the electrodes 7 and the catalyst carrier 3 may become electrically conductive with one another also by means of the condensed water itself absorbed in the mat 5.

In addition, a part of the PM contained in the exhaust gas adheres to the end face of the mat 5 and the protrusion portion of the inner pipe 6 which are exposed to the exhaust gas. The PM has electric conductivity. For that reason, when the PM deposited on the end face of the mat 5 and the protrusion portion of the inner pipe 6 increases, the case 4 and the catalyst carrier 3 will become electrically conductive by means of the PM, and the insulation resistance value of the insulating member 30 will decrease. Here, note that even with a construction in which the inner pipe 6 is not provided, there is a fear that the case 4 and the catalyst carrier 3 may become electrically conductive with each other by means of the PM deposited on the end face of the mat 5.

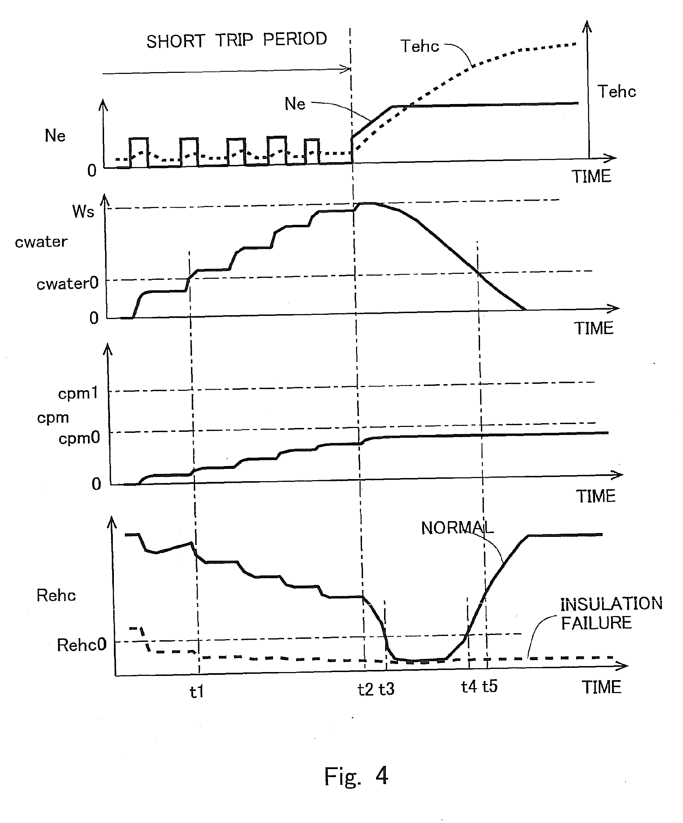

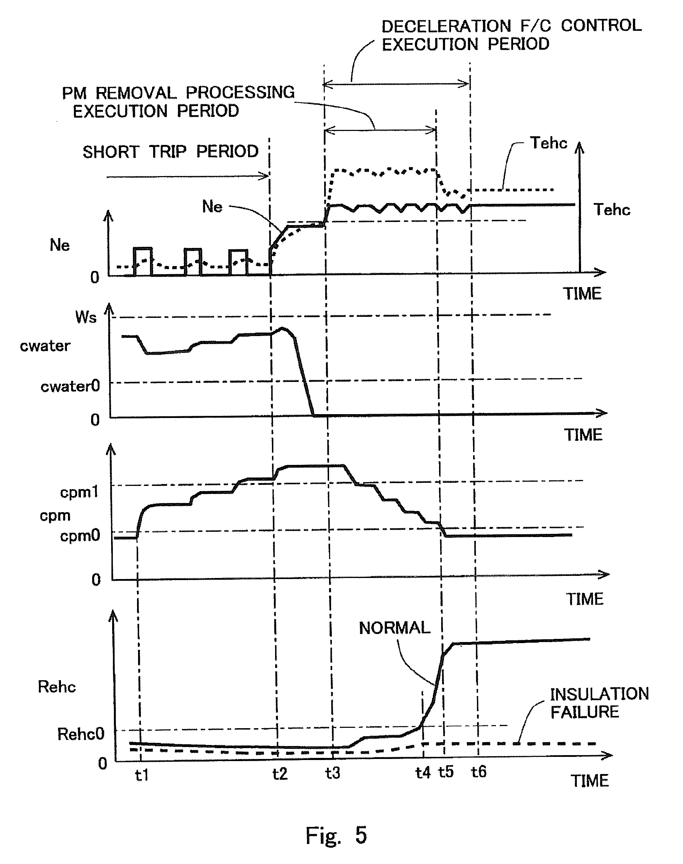

Accordingly, in this embodiment, insulation failure is detected in distinction from a reduction in the insulation resistance value resulting from such condensed water or PM. Here, reference will be made, based on Figs. 4 and 5, to changes over time of an engine rotational speed Ne, a temperature Tehc of the EHC 1, the amount of condensed water (hereinafter, may also be simply referred to as the amount of water absorption) cwater absorbed in the mat 5, the amount of PM (hereinafter, may also be referred to as the amount of PM deposition) cpm deposited on the end face and the inner pipe 6 of the mat 5, and the insulation resistance value Rehc of the insulating member 30. Fig. 4 is a time chart showing a first example of the changes over time of these values, and Fig. 5 is a time chart showing a second example of the changes over time of these values.

Here, note that in each of Figs. 4 and 5, the temperature Tehc of the EHC 1 shows the change over time of the temperature thereof in a state where electrical energization to the EHC 1 is not carried out. In addition, in each view showing the changes over time of the insulation resistance value Rehc of the insulating member 30, a solid line indicates the change over time thereof in the case where the EHC 1 is normal, i.e., in the case where insulation failure has not occurred, and a broken line indicates the change over time thereof in the case where insulation failure has occurred.

Fig. 4 shows the changes over time of individual values when the operation of the internal combustion engine 10 is continued, after a so-called short trip, in which the operation of the internal combustion engine 10 is stopped for a short time after the starting thereof, is carried out in a repeated manner. In Fig. 4, the short trip is carried out in a repeated manner until a point in time t2. Then, after the point in time t2, the operation of the internal combustion engine 10 is continued after the starting thereof. In the period of time (i.e., short trip period) in which the short trip is carried out in a repeated manner, after the starting of the internal combustion engine 10, the operation thereof is stopped before the temperature of the EHC 1 is raised to a sufficient extent by the exhaust gas. For that reason, the temperature of the EHC 1 is maintained at low temperature.

Here, when the temperature of the exhaust gas is low, i.e., immediately after the starting of the internal combustion engine 10, it is easy to generate condensed water in the exhaust pipe 2. In addition, immediately after the starting of the internal combustion engine 10, the temperature in each cylinder is low, it is easy for PM to be emitted from the internal combustion engine 10. For that reason, in the short trip period, the amount of water absorption cwater and the amount of PM deposition cpm each increase with the passage of time.

Then, when the temperature of the EHC 1 goes up to a sufficient extent by the operation of the internal combustion engine 10 being continued after the point in time t2, the condensed water absorbed in the mat 5 will evaporate. For that reason, the amount of water absorption cwater decreases with the passage of time. In addition, it becomes difficult for the PM to be emitted from the internal combustion engine 10, the amount of PM deposition cpm is maintained.

At this time, the insulation resistance value Rehc of the insulating member 30 decreases according to the increase in the amount of water absorption cwater and in the amount of PM deposition cpm in the short trip period, even if the EHC 1 is in a normal state. Then, after a point in time t3, the insulation resistance value Rehc becomes equal to or less than a predetermined resistance value Rehc0 which is a threshold value with which it can be determined that insulation failure has occurred. However, after that, the insulation resistance value Rehc of the insulating member 30 is restored (i.e., goes up) according to the decrease in the amount of water absorption cwater due to evaporation. Then, after a point in time t4, the insulation resistance value Rehc becomes higher than the predetermined resistance value Rehc0.

On the other hand, in cases where the insulation resistance value Rehc of the insulating member 30 has decreased to equal to or less than the predetermined resistance value Rehc0 due to the occurrence of insulation failure, even if the amount of water absorption cwater decreases, the insulation resistance value Rehc is not restored (maintained equal to or less than the predetermined resistance value Rehc0).

Fig. 5 shows the changes over time of the respective values in cases where so-called deceleration fuel cut-off control (deceleration F/C control) is carried out intermittently during the continuation of the internal combustion engine 10 after the lapse of the short trip period, and where PM removal processing is further performed when the deceleration fuel cut-off control is carried out intermittently. In Fig. 5, too, until the point in time t2, a short trip is carried out in a repeated manner, and after the point in time t2, the operation of the internal combustion engine 10 is carried out in a continuous manner.

In Fig. 5, after the point in time t2, the amount of water absorption cwater decreases to substantially zero due to the evaporation of condensed water accompanying the rise in temperature of the EHC 1. In addition, in the short trip period, the amount of PM deposition cpm increases equal to or more than a threshold value cpm1 for an execution request of PM removal processing to remove by oxidation the PM deposited on the end face of the mat 5 and the inner pipe 6.

Then, from the point in time t3 to a point in time t6, when the operating state of the internal combustion engine 10 is a deceleration operation, deceleration F/C control to stop fuel injection is carried out intermittently. Here, in order to oxidize the PM deposited on the end face of the mat 5 and the protrusion portion of the inner pipe 6, it is necessary to raise the temperature of the exhaust gas (the temperatures of the end face of the mat 5 and the protrusion portion of the inner pipe 6) under the state of existence of a sufficient amount of oxygen, to a temperature at which oxidation of the PM becomes possible. Immediately after the end of deceleration F/C control, there exists a sufficient amount of oxygen in the surroundings of the EHC 1. For that reason, the PM removal processing is achieved by raising the temperature of the exhaust gas by the retardation of ignition timing, etc., immediately after restoration from deceleration F/C control.

In Fig. 5, when the execution of the intermittent deceleration F/C control is started at the point in time t3, the execution of PM removal processing will also be started. As a result of this, after the point in time t3, the PM deposited on the end face of the mat 5 and the protrusion portion of the inner pipe 6 is oxidized, so the amount of PM deposition cpm decreases with the passage of time. Then, the execution of the PM removal processing is stopped at a point in time t5 at which the amount of PM deposition cpm decreases to below the predetermined amount of PM deposition which is smaller than the threshold value cpm1 for the execution request of PM removal processing.

At this time, the insulation resistance value Rehc of the insulating member 30 is maintained at a value lower than the predetermined resistance value Rehc0, during the short trip period in which the amount of water absorption cwater and the amount of PM deposition cpm are both large, and in a period of time before the point in time t3 at which the execution of PM removal processing after the point in time t2 from which the operation of the internal combustion engine 10 is performed in a continuous manner is started, even if the EHC 1 is in a normal state. However, after that, the insulation resistance value Rehc of the insulating member 30 is restored (i.e., goes up) according to the decrease in the amount of PM deposition Rehc due to the execution of PM removal processing. Then, after the point in time t4, the insulation resistance value Rehc becomes higher than the predetermined resistance value Rehc0.

On the other hand, in cases where the insulation resistance value Rehc of the insulating member 30 has decreased to equal to or less than the predetermined resistance value Rehc0 due to the occurrence of insulation failure, even if the amount of PM deposition cpm decreases, the insulation resistance value Rehc is not restored (i.e., maintained equal to or less than the predetermined resistance value Rehc0).

Accordingly, in this embodiment, in cases where the insulation resistance value of the insulating member 30 at the time when the amount of water absorption is smaller than a predetermined amount of water absorption (cwater0 in Figs. 4 and 5) and when the amount of PM deposition is smaller than a predetermined amount of PM deposition (cpm0 in Figs. 4 and 5) is equal to or less than a predetermined resistance value (Rcehc in Figs. 4 and 5), a determination is made that insulation failure has occurred. Here, the predetermined amount of water absorption and the predetermined amount of PM deposition are set as such values that if insulation failure does not occur, if the amount of water absorption is smaller than the predetermined amount of water absorption, and if the amount of PM deposition is smaller than the predetermined amount of PM deposition, the insulation resistance value of the insulating member 30 will be a normal value (i.e., a value larger than the predetermined resistance value RehcO), and these values are determined in advance based on experiments, etc.

Further, in cases where the insulation resistance value of the insulating member 30 is equal to or less than the predetermined resistance value when the amount of water absorption is equal to or larger than the predetermined amount of water absorption, a determination as to whether insulation failure has occurred is suspended until the amount of water absorption decreases below the predetermined amount of water absorption (i.e., in a period of time from the point in time t3 to the point in time t5 in Fig. 4) . Then, in cases where the insulation resistance value of the insulating member 30 goes up above the predetermined resistance value when the amount of water absorption decreases below the predetermined amount of water absorption, it is determined that a cause of the reduction in the insulation resistance value of the insulating member 30 is the condensed water (condensed water invaded into the electrode chamber 9) which has been absorbed into the mat 5. In other words, in this case, a determination is made that insulation failure has not occurred and that the EHC 1 is normal.

In addition, in cases where the insulation resistance value of the insulating member 30 is equal to or less than the predetermined resistance value when the amount of PM deposition is equal to or larger than the predetermined amount of PM deposition, a determination as to whether insulation failure has occurred is suspended until the amount of PM deposition decreases below the predetermined amount of PM deposition (i.e., in a period of time from the point in time t1 to the point in time t5 in Fig. 5). Then, in cases where the insulation resistance value of the insulating member 30 goes up above the predetermined resistance value when the amount of PM deposition decreases below the predetermined amount of PM deposition, it is determined that a cause of the reduction in the insulation resistance value of the insulating member 30 is the PM which has deposited on the end face of the mat 5 and the protrusion portion of the inner pipe 6. In other words, in this case, too, a determination is made that insulation failure has not occurred and that the EHC 1 is normal.

[Calculation Method for the Amount of Water Absorption]

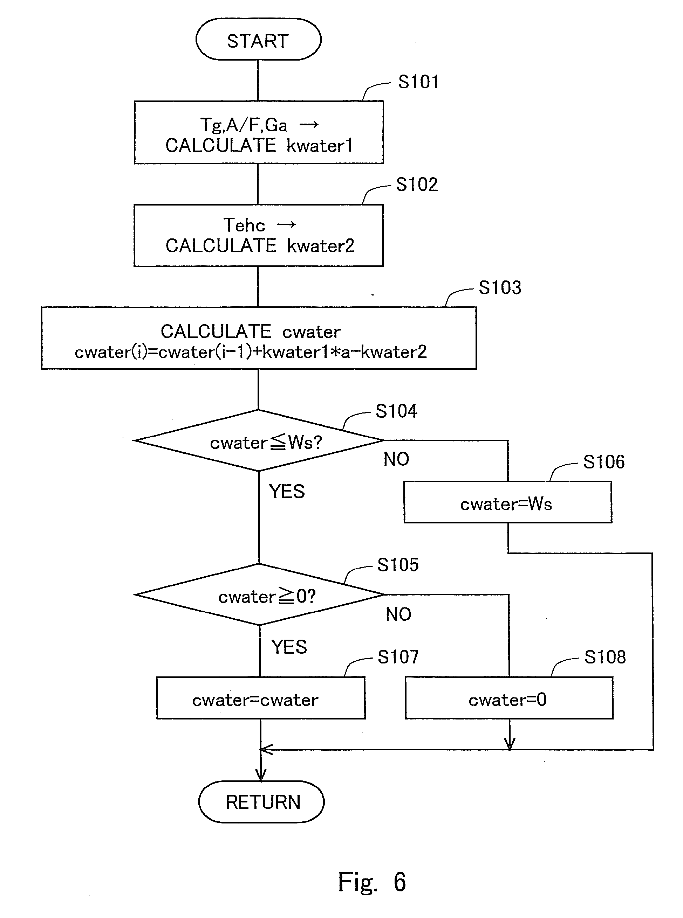

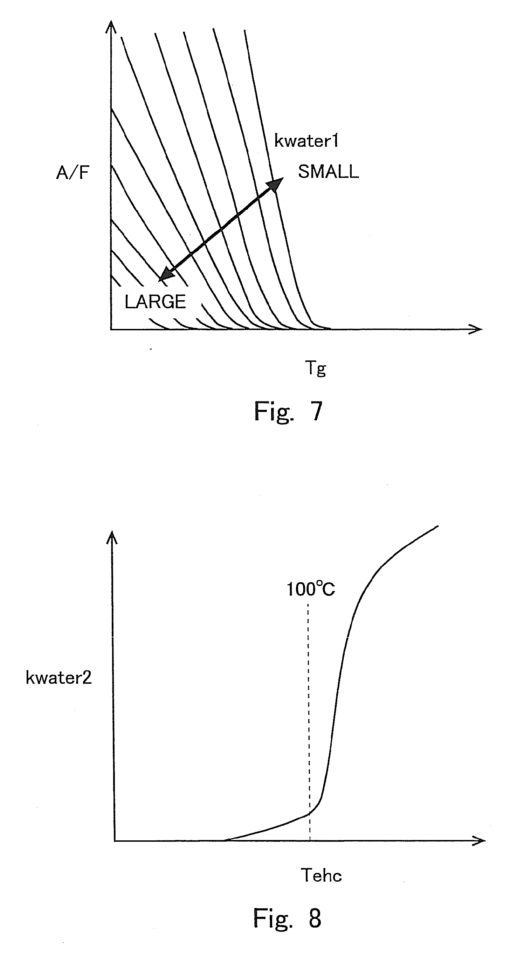

Here, reference will be made to a calculation method for the amount of water absorption according to this embodiment based on Figs. 6 through 8. Fig. 6 is a flow chart showing a calculation flow or routine for the amount of water absorption according to this embodiment. This flow has been beforehand stored in the ECU 20, and is executed by the ECU 20 in a repeated manner. Fig. 7 is a view showing the relation among an exhaust gas temperature Tg, an air fuel ratio A/F of an air fuel mixture and an amount of generation kwater1 of condensed water in the exhaust pipe 2. Fig. 8 is a view showing the relation between the temperature Tehc of the EHC and an amount of evaporation kwater2 of condensed water from the mat 5.

In the flow shown in Fig. 6, first in step S101, the amount of generation kwater1 of the condensed water in the exhaust pipe 2 is calculated based on the exhaust gas temperature Tg detected by the first temperature sensor 23, the air fuel ratio A/F of the air fuel mixture, and the amount of intake air Ga detected by the air flow meter 12.

As shown in Fig. 7, the lower the air fuel ratio A/F of the air fuel mixture, and the lower the exhaust gas temperature Tg, the amount of generation kwater1 of condensed water becomes larger. In addition, the larger the amount of intake air, the larger the flow rate of the exhaust gas also becomes larger, and hence, the amount of generation kwater1 of condensed water increases. Such a relation among the exhaust gas temperature Tg, the air fuel ratio A/F of the air fuel mixture, the amount of intake air Ga, and the amount of generation kwater1 of condensed water in the exhaust pipe 2 can be obtained in advance based on experiments, etc., and has been stored in the ECU 20 as a map or a function. In step S101, the amount of generation kwater1 of condensed water in the exhaust pipe 2 is calculated by the use of this map or function.

Then, in step S102, the amount of evaporation kwater2 of condensed water from the mat 5 is calculated based on the temperature Tehc of the EHC 1. As shown in Fig. 8, when the temperature Tehc of the EHC 1 reaches 100 degrees C or above, the amount of evaporation kwater2 of condensed water will increase in a rapid manner. Such a relation between the temperature Tehc of the EHC 1 and the amount of evaporation kwater2 of condensed water from the mat 5 can be obtained in advance based on experiments, etc., and has been stored in the ECU 20 as a map or a function. In step S102, the amount of evaporation kwater2 of condensed water from the mat 5 is calculated by the use of this map or function. Here, note that the temperature of the EHC 1 can be estimated based on at least either one of the exhaust gas temperature detected by the first temperature sensor 23, and the exhaust gas temperature detected by the second temperature sensor 24.

Subsequently, in step S103, the amount of water absorption cwater is calculated by using the following expression (1).

$$cwater(i) = cwater(i-1) + kwater1*a - kwater2 \ldots Expression (1)$$

cwater(i): a current amount of water absorption;
cwater(i - 1) : an amount of water absorption calculated by the last execution of this flow;
kwater1 : the amount of generation of condensed water calculated in step S101;
a: a coefficient which represents a ratio of the amount of condensed water absorbed in the mat 5 with respect to the amount of generation of condensed water in the exhaust pipe 2; and
kwater2 : the amount of evaporation of condensed water calculated in step S102.

Thereafter, in step S104, it is determined whether the value cwater calculated in step S103 is equal to or less than a saturation amount of water absorption Ws in the mat 5. In cases where a negative determination is made in step S104, then in step S106, the saturation amount of water absorption Ws is calculated as a calculated value of the amount of water absorption cwater.

On the other hand, in cases where an affirmative determination is made in step S104, then in step S105, it is determined whether the value cwater calculated in step S103 is equal to or larger than zero. In cases where a negative determination is made in step S105, then in step S108, the calculated value of the amount of water absorption cwater is calculated as zero. On the other hand, in cases where an affirmative determination is made in step S105, then in step S107, the amount of water absorption cwater calculated in step S103 is calculated as the calculated value of the amount of water absorption cwater.

[Calculation Method for the Amount of PM Deposition]

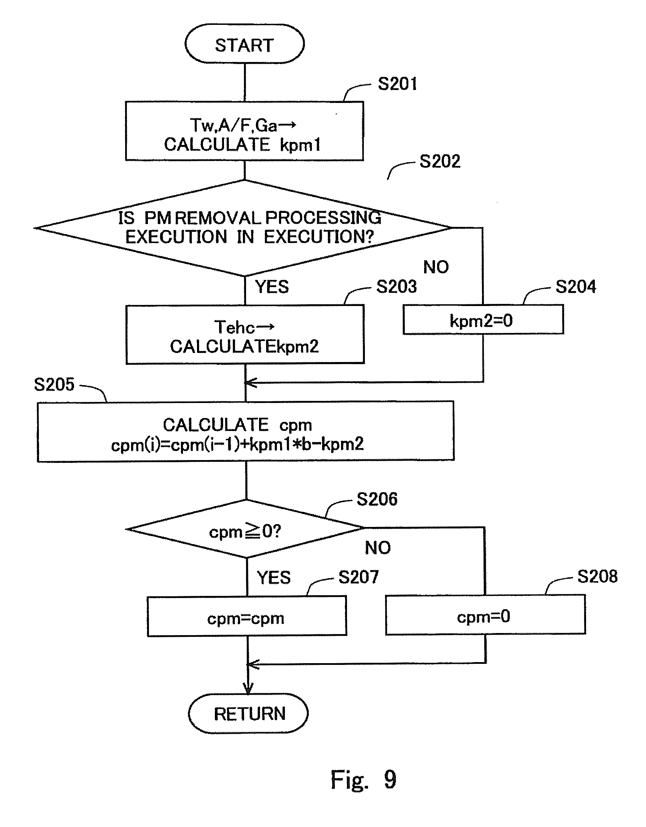

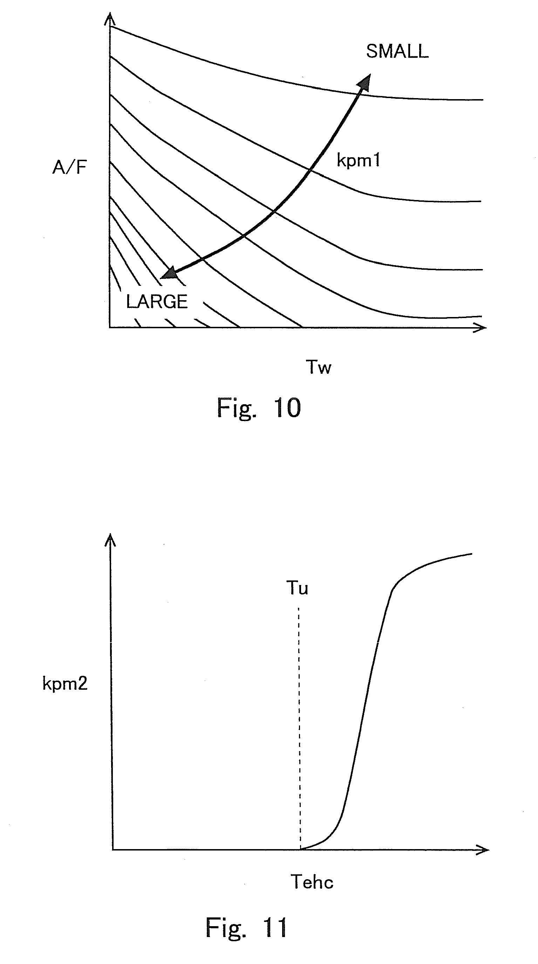

Next, reference will be made to a calculation method for the amount of PM deposition according to this embodiment, based on Figs. 9 through 11. Fig. 9 is a flow chart which represents a calculation flow for the amount of PM deposition according to this embodiment. This flow has been beforehand stored in the ECU 20, and is executed by the ECU 20 in a repeated manner. Fig. 10 is a view showing the relation between a temperature Tw of cooling water, the air fuel ratio A/F of the air fuel mixture, and an amount of emission kpm1 of PM from the internal combustion engine 1. Fig. 11 is a view showing the relation between the temperature Tehc of the EHC 1 and an amount of oxidation kpm2 of particulate matter deposited on the end face of the mat 5 or the protrusion portion of the inner pipe 6, under a state where there exists a sufficient amount of oxygen for oxidizing particulate matter, according to the first embodiment.

In the flow shown in Fig. 9, first in step S201, the amount of emission kpm1 of particulate matter discharged from the internal combustion engine 1 is calculated based on the cooling water temperature Tw detected by the water temperature sensor 22, the air fuel ratio A/F of the air fuel mixture, and the amount of intake air Ga detected by the air flow meter 12.

As shown in Fig. 10, the lower the cooling water temperature Tw, and the lower the air fuel ratio A/F of the air fuel mixture, the larger becomes the amount of emission kpm1 of particulate matter. In addition, the larger the amount of intake air, the flow rate of the exhaust gas also becomes larger, and hence, the amount of emission kpm1 of particulate matter increases. Such a relation among the cooling water temperature Tw, the air fuel ratio A/F of the air fuel mixture, the amount of intake air Ga, and the amount of emission kpm1 of particulate matter discharged from the internal combustion engine 1 can be obtained in advance based on experiments, etc., and has been stored in the ECU 20 as a map or a function. In step S201, the amount of emission kpm1 of particulate matter discharged from the internal combustion engine 1 is calculated by the use of this map or function.

Subsequently, in step S202, it is determined whether the above-mentioned PM removal processing is in the course of execution. In cases where an affirmative determination is made in step S202, the processing of step S203 is then carried out. In step S203, the amount of oxidation kpm2 of the particulate matter deposited on the end face of the mat 5 or on the protrusion portion of the inner pipe 6 is calculated based on the temperature Tehc of the EHC 1. As shown in Fig. 11, under the condition where there exists a sufficient amount of oxygen for oxidizing particulate matter, when the temperature Tehc of the EHC 1 becomes equal to or higher than a temperature Tu at which the particulate matter can be oxidized, the amount of oxidation of the particulate matter will become larger as the temperature thereof is higher. Such a relation between the temperature Tehc of the EHC 1 and the amount of oxidation kpm2 of the particulate matter deposited on the end face of the mat 5 or the protrusion portion of the inner pipe 6 can be obtained in advance based on experiments, etc., and has been stored in the ECU 20 as a map or a function. In step S203, the amount of oxidation kpm2 of the particulate matter deposited on the end face of the mat 5 or the protrusion portion of the inner pipe 6 is calculated by the use of this map or function.

On the other hand, in cases where a negative determination is made in step S202, PM removal processing is not carried out, so the PM is not oxidized. In this case, subsequently in step S204, the amount of oxidation kpm2 of the particulate matter deposited on the end face of the mat 5 or the protrusion portion of the inner pipe 6 is calculated as zero by the use of this map or function.

Subsequent to the processing of step S203 or S204, the processing of step S205 is carried out. In step S205, the amount of PM deposition cpm is calculated by using the following expression (2).

$$cpm(i) = cpm(i - 1) + kpm1*b - kpm2 \ldots \text{Expression (1)}$$

cpm(i): a current amount of PM deposition
cpm(i - 1): an amount of PM deposition calculated by the last execution of this flow;
kpm1 : the amount of emission of particulate matter calculated in step S201;
b: a coefficient which represents a ratio of the amount of the particulate matter adhered to the end face of the mat 5 or the protrusion portion of the inner pipe 6 with respect to the amount of emission of the particulate matter discharged from the internal combustion engine 1; and
kpm2: the amount of oxidation of the particulate matter calculated in step S203 or S204

Thereafter, in step S206, it is determined whether the value cpm calculated in step S205 is equal to or larger than zero. In cases where a negative determination is made in step S206, then in step S208, the calculated value of the amount of PM deposition cpm is calculated as zero. On the other hand, in cases where an affirmative determination is made in step S206, then in step S207, the amount of PM deposition cpm calculated in step S205 is calculated as the calculated value of the amount of PM deposition cpm.

[Detection Flow for Insulation Failure]

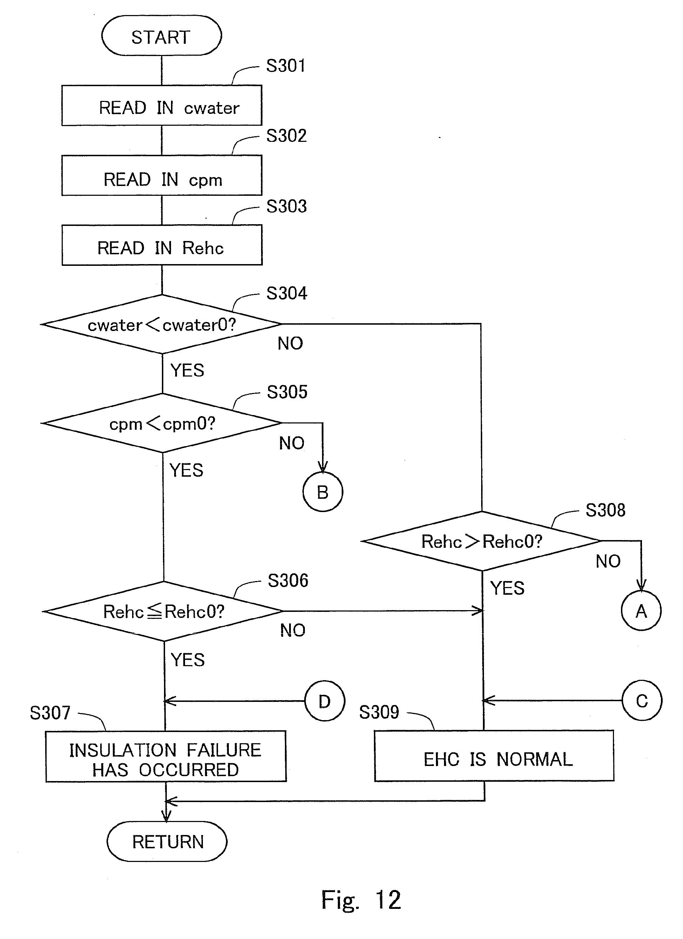

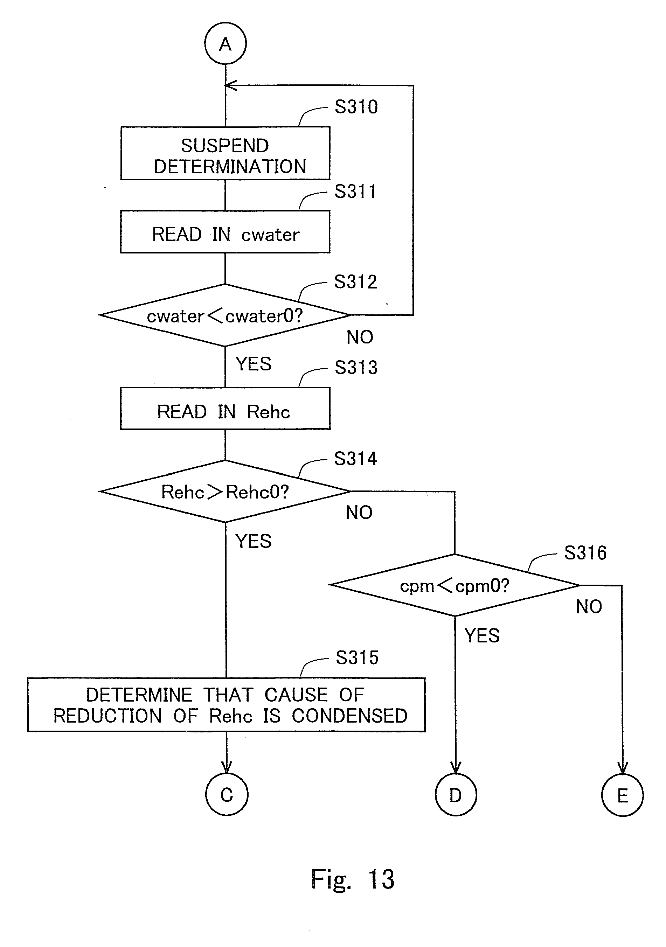

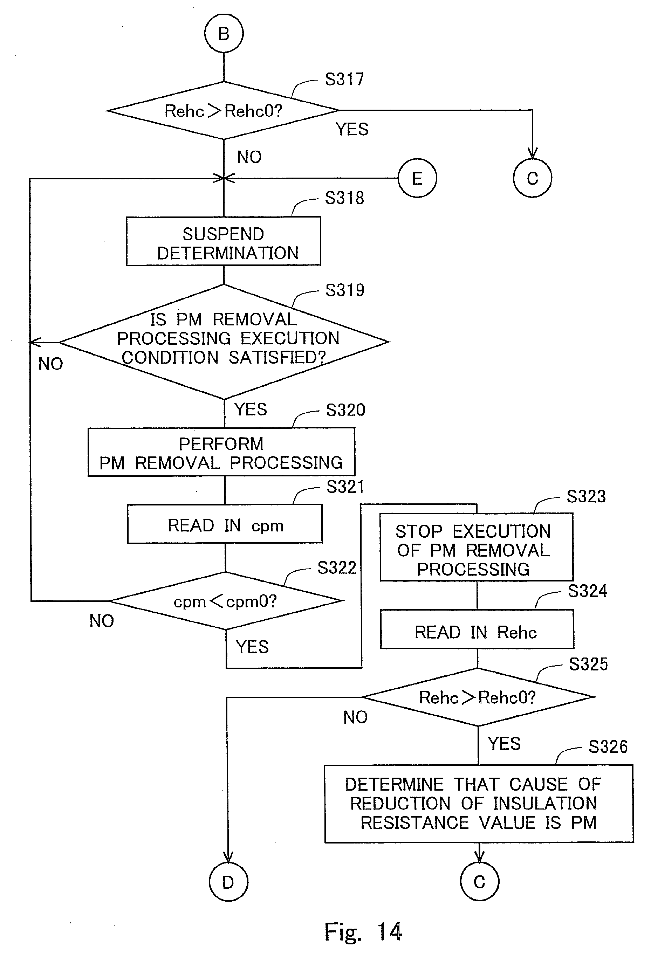

Next, reference will be made to a detection flow for insulation failure according to this embodiment, based on Figs. 12 through 14. Figs. 12 through 14 are flow charts showing the detection flow or routine for insulation failure according to this embodiment. This flow has been beforehand stored in the ECU 20, and is executed by the ECU 20 in a repeated manner when electrical energization to the EHC 1 is not carried out.

In this flow, first in step S301, the amount of water absorption cwater at the current point in time calculated by the execution of the above-mentioned calculation flow for the amount of water absorption is read in. Then, in step S302, the amount of PM deposition cpm at the current point in time calculated by the execution of the above-mentioned calculation flow for the amount of PM deposition is read in. Subsequently, in step S303, the insulation resistance value Rehc of the insulating member 30 at the current point in time measured by the measuring device 21 is read in.

Thereafter, in step S304, it is determined whether the amount of water absorption cwater read in step S301 is equal to or less than a predetermined amount of water absorption cwater0. In cases where a negative determination is made in step S304, the processing of step S308 is then carried out.

On the other hand, in cases where an affirmative determination is made in step S304, then in step S305, it is determined whether the amount of PM deposition cpm read in step S302 is smaller than a predetermined amount of PM deposition cpm0. In cases where a negative determination is made in step S305, the processing of step S317 is then carried out.

On the other hand, in cases where an affirmative determination is made in step S305, then in step S306, it is determined whether the insulation resistance value Rehc read in step S303 is equal to or less than the predetermined resistance value Rehc0.

In cases where an affirmative determination is made in step S306, i.e., in cases where the insulation resistance value Rehc of the insulating member 30 at the time when the amount of water absorption cwater is smaller than the predetermined amount of water absorption cwater0 and when the amount of PM deposition cpm is smaller than the predetermined amount of PM deposition cpm0 is equal to or less than the predetermined resistance value Rehc0, then in step S307, a determination is made that insulation failure has occurred. On the other hand, in cases where a negative determination is made in step S306, then in step S309, a determination is made that insulation failure has not occurred and that the EHC 1 is normal.

In addition, in step S308, it is determined whether the insulation resistance value Rehc read in step S303 is larger than the predetermined resistance value Rehc0. In cases where an affirmative determination is made in step S308, then in step S309, a determination is made that insulation failure has not occurred and that the EHC 1 is normal. On the other hand, in cases where a negative determination is made in step S308, the processing of step S310 is then carried out. In step S310, a determination as to whether insulation failure has occurred is suspended.

Subsequently, in step S311, the amount of water absorption cwater is read in again. And then, in step S312, it is determined whether the amount of water absorption cwater read in step S311 is smaller than the predetermined amount of water absorption cwater0. In cases where an affirmative determination is made in step S312, in other words, in cases where the amount of water absorption has been decreased due to evaporation from an amount equal to or more than the predetermined amount of water absorption cwater0 to an amount smaller than the predetermined amount of water absorption cwater0, the processing of step S313 is then carried out. On the other hand, in cases where a negative determination is made in step S312, the processing of steps S310 through S312 is again carried out. In other words, a determination as to whether insulation failure has occurred is suspended until the amount of water absorption decreases below the predetermined amount of water absorption cwater0.

In step S313, the insulation resistance value Rehc of the insulating member 30 at the current point in time measured by the measuring device 21 (i.e., an insulation resistance value under a state where the amount of water absorption is smaller than the predetermined amount of water absorption cwater0) is read in. Subsequently, in step S314, it is determined whether the insulation resistance value Rehc read in step S313 is larger than the predetermined resistance value Rehc0. In cases where an affirmative determination is made in step S314, in other words, in cases where the insulation resistance value has been restored due to the fact that the amount of water absorption decreases below the predetermined amount of water absorption cwater0, the processing of step S315 is then carried out.

In step S315, it is determined that the cause of the decrease in the insulation resistance value is the condensed water absorbed in the mat 5. And, then in step S309, it is determined that insulation failure has not occurred, and that the EHC 1 is normal.

On the other hand, in cases where a negative determination is made in step S314, the processing of step S316 is then carried out. In step S316, it is determined whether the amount of PM deposition cpm read in step S302 is smaller than the predetermined amount of PM deposition cpm0. In cases where an affirmative determination is made in step S316, it is then determined in step S307 that insulation failure has occurred. On the other hand, in cases where a negative determination is made in step S316, the processing of step S318 is then carried out.

In addition, in step S317, it is determined whether the insulation resistance value Rehc read in step S303 is larger than the predetermined resistance value Rehc0. In cases where an affirmative determination is made in step S317, then in step S309, it is determined that insulation failure has not occurred, and that the EHC 1 is normal. On the other hand, in cases where a negative determination is made in step S317, then in step S318, a determination as to whether insulation failure has occurred is suspended.

Subsequently, in step S319, it is determined whether an execution condition for PM removal processing is satisfied, i.e., whether deceleration F/C control is carried out intermittently. In cases where an affirmative determination is made in step S319, then in step S320, PM removal processing is carried out. On the other hand, in cases where a negative determination is made in step S319, the processing of steps S318 and S319 is again carried out.

Subsequent to step S320, in step S321, the amount of PM deposition cpm is again read in. Then, in step S322, it is determined whether the amount of PM deposition cpm read in step S321 is smaller than the predetermined amount of PM deposition cpm0. In cases where an affirmative determination is made in step S312, in other words, in cases where the amount of PM deposition has been decreased due to the execution of the PM removal processing from an amount equal to or more than the predetermined amount of PM deposition cpm0 to an amount smaller than the predetermined amount of PM deposition cpm0, the processing of step S323 is then carried out. On the other hand, in cases where a negative determination is made in step S322, the processing of steps S318 through S322 is again carried out. In other words, a determination as to whether insulation failure has occurred is suspended until the amount of PM deposition decreases below the predetermined amount of PM deposition cpm0.

In step S323, the execution of the PM removal processing is stopped. Then, in step S324, the insulation resistance value Rehc of the insulating member 30 at the current point in time measured by the measuring device 21 (i.e., an insulation resistance value under a state where the amount of PM deposition is smaller than the predetermined amount of PM deposition cpm0) is read in. Subsequently, in step S325, it is determined whether the insulation resistance value Rehc read in step S324 is larger than the predetermined resistance value Rehc0. In cases where an affirmative determination is made in step S325, in other words, in cases where the insulation resistance value has been restored due to the fact that the amount of PM deposition decreases below the predetermined amount of PM deposition cpm0, the processing of step S326 is then carried out.

In step S326, it is determined that the cause of the decrease in the insulation resistance value is the PM deposited on the end face of the mat 5 and the protrusion portion of the inner pipe 6. And, then in step S309, it is determined that insulation failure has not occurred, and that the EHC 1 is normal.

On the other hand, in cases where a negative determination is made in step S325, it is then determined in step S307 that insulation failure has occurred.

According to the above-mentioned flow, a determination as to whether insulation failure has occurred can be made, by making a distinction from a reduction in the insulation resistance value of the insulating member 30 resulting from the condensed water absorbed in the mat 5 or the particulate matter deposited on the end face of the mat 5 and the protrusion portion of the inner pipe 6.

Here, note that if the temperature of the EHC 1 has reached an upper limit value of an active region (i.e., a temperature zone where the exhaust gas purification performance of the EHC 1 becomes the highest), electrical energization to the EHC 1 will not be carried out. Accordingly, it is not necessary to detect insulation failure. For that reason, when the temperature of the EHC 1 is equal to or larger than the upper limit value of the active region, a determination as to whether insulation failure has occurred, as mentioned above, may not be made.

[Modification]

In the following, reference will be made to a first modification and a second modification of this embodiment. The insulating member 30 has a characteristic that even if in a normal state, the insulation resistance value thereof decreases as the temperature of the insulating member 30 goes up. Accordingly, in the first and second modifications, the predetermined resistance value, which is an insulation resistance value used as a threshold value for determining whether insulation failure has occurred in the above-mentioned detection flow for insulation failure, is changed according to the temperature of the EHC 1. In other words, the higher the temperature of the EHC 1, the higher becomes the temperature of the insulating member 30, so the predetermined resistance value is set to be smaller.

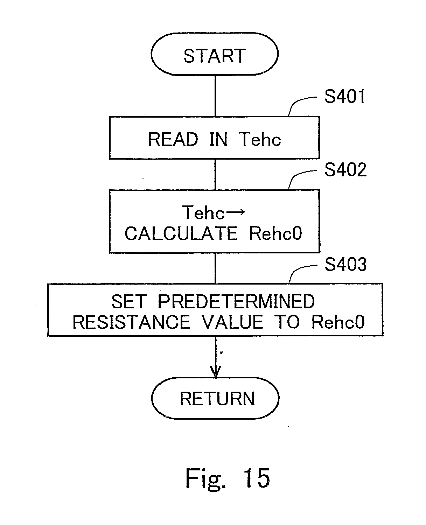

Here, reference will be made to a setting flow for a predetermined resistance value according to the first modification, based on Fig. 15. Fig. 15 is a flow chart showing the setting flow for a predetermined resistance value according to the first modification. This flow has been beforehand stored in the ECU 20, and is executed by the ECU 20 in a repeated manner.

In this flow, first in step S401, the temperature Tehc of the EHC 1 is read in. Here, note that the temperature Tehc of the EHC 1 is estimated based on at least either one of the exhaust gas temperature detected by the first temperature sensor 23, and the exhaust gas temperature detected by the second temperature sensor 24.

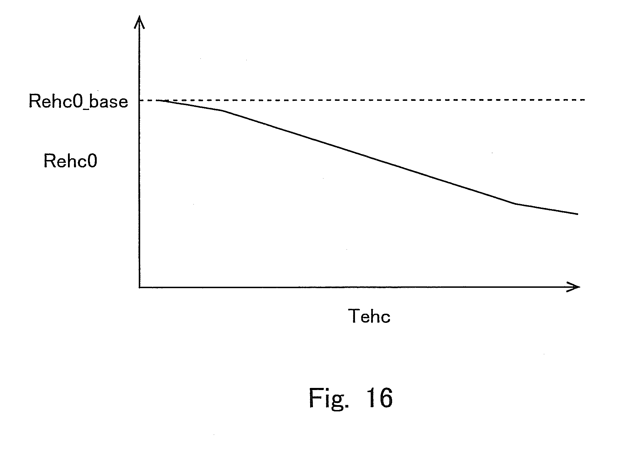

Then, in step S402, the predetermined resistance value Rehc0 is calculated based on the temperature Tehc of the EHC 1. Fig. 16 is a view showing the relation between the temperature Tehc of the EHC 1 and the predetermined resistance value Rehc0. In Fig. 16, the lower the temperature of the EHC 1, the smaller becomes the predetermined resistance value Rehc0. Such a relation between the temperature Tehc of the EHC 1 and the predetermined resistance value Rehc0 can be set in advance based on experiments, etc., and has been stored in advance in the ECU 20 as a map or a function. In step S402, the predetermined resistance value Rehc0 is calculated by the use of this map or function.

Subsequently, in step S403, the predetermined resistance value is set as the predetermined resistance value Rehc0 calculated in step S402. As a result of this, when the above-mentioned detection flow for insulation failure is carried out next time, the predetermined resistance value Rehc0 set in step S403 is used as a threshold value for determining whether insulation failure has occurred.

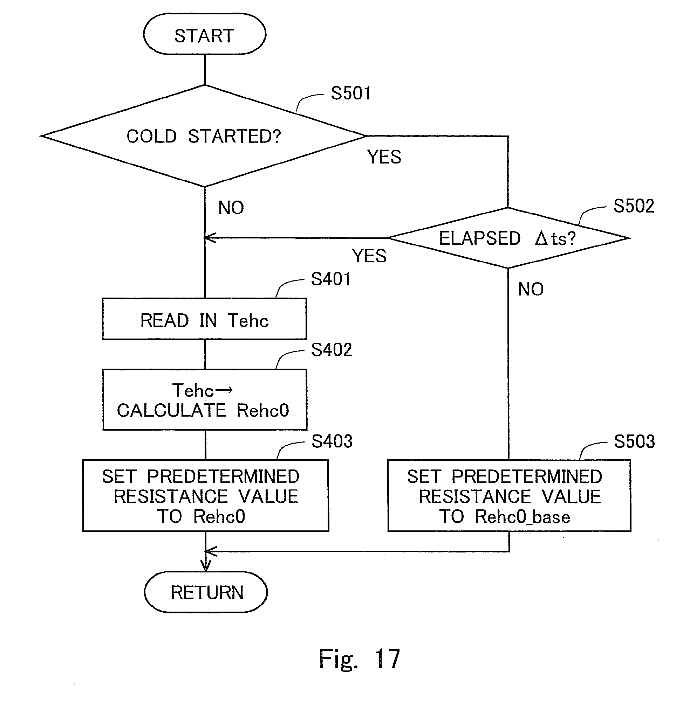

Next, reference will be made to a setting flow for a predetermined resistance value according to the second modification, based on Fig. 17. Fig. 17 is a flow chart showing the setting flow for a predetermined resistance value according to the second modification. This flow has been beforehand stored in the ECU 20, and is executed by the ECU 20 in a repeated manner. Here, note that in this flow, steps S501 through S503 are added to the flow shown in Fig. 15. Therefore, only processing in steps S501 through S503 will be explained, and the explanation of processing in the other steps will be omitted.

As stated above, as the temperature of the EHC 1 rises, the temperature of the insulating member 30 also rises accordingly. However, the insulating member 30 has a certain amount of heat capacity, so the temperature rise thereof is delayed. In addition, the inner pipe 6 is sandwiched or inserted in the mat 5, so the heat generated in the catalyst carrier 3 is hard to conduct to the inner pipe 6. For that reason, the temperature rise of the inner pipe 6 is in particular easily delayed.

For that reason, in cases where the internal combustion engine 10 has been cold started, the temperature of the insulating member 30 is maintained to be low in a period of time until a certain period of time elapses after the engine starting, even if the temperature of the EHC 1 rises. Therefore, during that period of time, the insulation resistance value of the insulating member 30 is maintained without decreasing.

Accordingly, in the second modification, during the period of time from the cold starting of the internal combustion engine 10 until the predetermined period of time elapses, the predetermined resistance value is maintained at a reference resistance value (Rehc_base in Fig. 16), even if the temperature of the EHC 1 rises. Here, the predetermined period of time is a period of time for which the temperature of the insulating member 30 is maintained to be low.

In the flow shown in Fig. 17, first in step S501, it is determined whether the internal combustion engine 10 has been cold started. Here, for example, in cases where the detected value of the water temperature sensor 22 at the time of the starting of the internal combustion engine 1 is equal to or less than a threshold value, a determination may be made that the internal combustion engine 10 has been cold started. In cases where a negative determination is made in step S501, the processing of step S401 is then carried out.

On the other hand, in cases where an affirmative determination is made in step S501, then in step S502, it is determined whether a predetermined period of time Δts has elapsed after the cold starting of the internal combustion engine 10. In cases where an affirmative determination is made in step S502, the processing of step S401 is then carried out.

On the other hand, in cases where a negative determination is made in step S502, then in step S503, the predetermined resistance value is set to the reference resistance value Rehc0_base. As a result of this, at the time when the above-mentioned detection flow for insulation failure is carried out next time, the reference resistance value Rehc0_base is used as a threshold value for determining whether insulation failure has occurred.

According to the above-mentioned modification, it is possible to detect insulation failure with a higher degree of accuracy.

<Second Embodiment>

The schematic construction of intake and exhaust systems and an EHC of an internal combustion engine according to this second embodiment is the same as that in the first embodiment. In addition, in this embodiment, too, detection of insulation failure is carried out by the same method as in the first embodiment, but in this embodiment, the detection of insulation failure is further carried out by the following method, too.

[Detection Method for Insulation Failure]

In addition, when the engine load of the internal combustion engine 10 changes, the temperature of the exhaust gas will change, so the temperature of the EHC 1 will change. As a result, the temperature of the insulating member 30 will change, and hence, if the EHC 1 is normal (i. e. , if insulation failure has not occurred), the insulation resistance value of the insulating member 30 will change. In other words, when the temperature of the insulating member 30 rises, the insulation resistance value thereof will decrease, whereas when the temperature of the insulating member 30 falls, the insulation resistance value thereof will increases.

However, when insulation failure has occurred, even if the temperature of the insulating member 30 changes, the insulation resistance value of the insulating member 30 will not change according to that. In other words, an amount of change in the insulation resistance value of the insulating member 30 measured by the measuring device 21 becomes very small in comparison with that at the time of normal operation. Accordingly, in this embodiment, based on the change in the insulation resistance value of the insulating member 30 according to a change in the engine load of the internal combustion engine 10, it is determined whether insulation failure has occurred.

[Detection Flow for Insulation Failure]

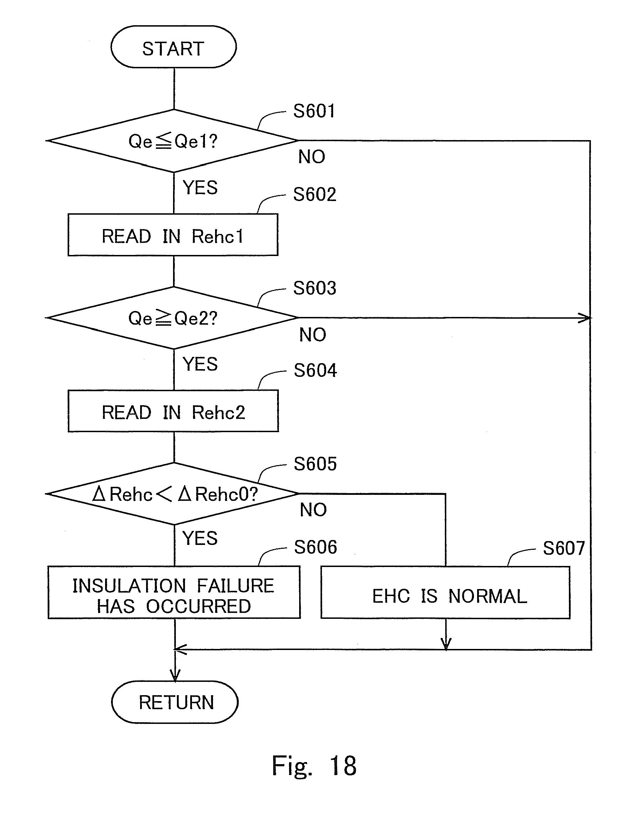

Here, reference will be made to a detection flow for insulation failure according to this embodiment, based on Fig. 18. Fig. 18 is a flow chart showing the detection flow for insulation failure according to this embodiment. This flow has been beforehand stored in the ECU 20, and is executed by the ECU 20 in a repeated manner when electrical energization to the EHC 1 is not carried out.

In this flow, first in step S601, it is determined whether the engine load Qe of the internal combustion engine 1 is equal to or less than a first predetermined load Qe1. In step S601, in cases where an affirmative determination is made, the processing of step S602 is then carried out, whereas in cases where a negative determination is made, the execution of this flow is once ended.

In step S602, an insulation resistance value Rehc1 of the insulating member 30 (hereinafter, this insulation resistance value being referred to as an insulation resistance value at the time of low load) is read in which has been measured by the measuring device 21 at the time when the amount of water absorption is smaller than the predetermined amount of water absorption and when the amount of PM deposition is smaller than the predetermined amount of PM deposition.

Then, in step S603, it is determined whether the engine load Qe of the internal combustion engine 1 is equal to or more than a second predetermined load Qe2 which is higher than the first predetermined load Qe1. In step S603, in cases where an affirmative determination is made, the processing of step S604 is then carried out, whereas in cases where a negative determination is made, the execution of this flow is once ended.

In step S604, an insulation resistance value Rehc2 of the insulating member 30 (hereinafter, this insulation resistance value being referred to as an insulation resistance value at the time of high load) is read in which has been measured by the measuring device 21 at the time when the amount of water absorption is smaller than the predetermined amount of water absorption and when the amount of PM deposition is smaller than the predetermined amount of PM deposition.

Subsequently, in step S605, it is determined whether a difference ΔRehc between the insulation resistance value Rehc1 at the time of the low load read in step S602 and the insulation resistance value Rehc2 at the time of high load read in step S604 is smaller than a predetermined resistance difference ΔRehc0. Here, the predetermined resistance difference ΔRehc0 is a threshold value with which it can be determined that the EHC 1 is normal. The predetermined resistance difference ΔRehc0 can be obtained in advance based on experiments, etc.

In cases where an affirmative determination is made in step S605, then in step S606, it is determined that insulation failure has occurred. On the other hand, in cases where a negative determination is made in step S605, then in step S607, a determination is made that insulation failure has not occurred and that the EHC 1 is normal.

Here, note that in this embodiment, a determination as to whether insulation failure has occurred may be made based on an amount of change in the insulation resistance value of the insulating member 30 at the time when the engine load of the internal combustion engine 10 has decreased from a value equal to or more than the second predetermined load Qe2 to a value equal to or less than the first predetermined load Qe1.

[DESCRIPTION OF THE REFERENCE SIGNS]

| | |
|---|---|
| 1 | electric heating catalyst (EHC) |
| 2 | exhaust pipe |
| 3 | catalyst carrier |
| 4 | case |
| 5 | mat |
| 6 | inner pipe |
| 7 | electrodes |
| 7a | surface electrodes |
| 7b | shaft electrodes |
| 10 | internal combustion engine |
| 11 | intake pipe |
| 12 | air flow meter |
| 13 | three-way catalyst |
| 20 | ECU |
| 21 | measuring device |
| 22 | water temperature sensor |
| 23 | first temperature sensor |
| 24 | second temperature sensor |
| 25 | supply power control unit |

**Claims**

1. A failure detection apparatus for an electrically heated catalyst, which detects a failure of the electrically heated catalyst arranged in an exhaust passage of an internal combustion engine, said apparatus comprising:

   a heat generation element that generates heat by electrical energization and heats the catalyst by the generation of heat; and
   an insulating member that electrically insulates said heat generation element;
   wherein a determination unit is provided that determines whether insulation failure has occurred, by making a distinction from a reduction in the insulation resistance value of said insulating member resulting from condensed water absorbed in said insulating member or resulting from particulate matter deposited on said insulatingmember, based on the insulation resistance value of said insulating member at the time when an amount of water absorption in said insulating member is smaller than a predetermined amount of water absorption and when an amount of deposition of particulate matter in said insulating member is smaller than a predetermined amount of PM deposition, a change in the insulation resistance value of said insulating member at the time when the amount of water absorption in said insulating member decreases from an amount equal to or larger than said predetermined amount of water absorption to an amount smaller than said predetermined amount of water absorption, and a change in the insulation resistance value of said insulating member at the time when the amount of deposition of particulate matter in said insulating member decreases from an amount equal to or larger than said predetermined amount of PM deposition to an amount smaller than said predetermined amount of PM deposition.

2. The failure detection apparatus for an electrically heated catalyst as set forth in claim 1, wherein said determination unit

makes a determination that insulation failure has occurred, in cases where the insulation resistance value of said insulating member is equal to or less than a predetermined resistance value, at the time when the amount of water absorption in said insulating member is smaller than said predetermined amount of water absorption and when the amount of deposition of particulate matter in said insulating member is smaller than said predetermined amount of PM deposition;

makes a determination that a cause of the reduction in the insulation resistance value of said insulating member is the condensed water which has been absorbed into said insulating member and that insulation failure has not occurred, in cases where the insulation resistance value of said insulating member is equal to or less than said predetermined resistance value when the amount of water absorption in said insulating member is equal to or larger than said predetermined amount of water absorption, and where the insulation resistance value of said insulating member goes up above said predetermined resistance value when the amount of water absorption in said insulating member decreases below said predetermined amount of water absorption; and

makes a determination that a cause of the reduction in the insulation resistance value of said insulating member is the particulate matter which has deposited on said insulating member and that insulation failure has not occurred, in cases where the insulation resistance value of said insulating member is equal to or less than said predetermined resistance value when the amount of deposition of particulate matter in said insulating member is equal to or larger than said predetermined amount of PM deposition, and where the insulation resistance value of said insulating member goes up above said predetermined resistance value when the amount of deposition of particulate matter in said insulating member decreases below said predetermined amount of PM deposition.

3. The failure detection apparatus for an electrically heated catalyst as set forth in claim 1 or 2, wherein said determination unit

suspends the determination of whether insulation failure has occurred, until the amount of water absorption in said insulating member decreases below said predetermined amount of water absorption, in cases where the insulation resistance value of said insulating member is equal toorless than said predetermined resistance value at the time when the amount of water absorption in said insulating member is equal to or larger than said predetermined amount of water absorption; and

suspends the determination of whether insulation failure has occurred, until the amount of deposition of particulate matter in said insulatingmember decreases below saidpredetermined amount of PM deposition, in cases where the insulation resistance value of said insulatingmember is equal to or less than saidpredetermined resistance value at the time when the amount of deposition of particulate matter in said insulating member is equal to or larger than said predetermined amount of PM deposition.

4. The failure detection apparatus for an electrically heated catalyst as set forth in any one of claims 1 through 3, further comprising:

a setting unit that sets said predetermined resistance value to a smaller value when the temperature of said electrically heated catalyst is high, in comparison with the time when the temperature thereof is low.

5. The failure detection apparatus for an electrically heated catalyst as set forth in claim 4, wherein during a period of time from cold starting of the internal combustion engine until a predetermined period of time elapses, said setting unit maintains said predetermined resistance value to a constant value, even if the temperature of said electrically heated catalyst rises.

6. The failure detection apparatus for an electrically heated catalyst as set forth in any one of claims 1 through 5, wherein said determination unit makes a determination that insulation failure has not occurred, in cases where the insulation resistance value of said insulating member, at the time when the amount of water absorption in said insulating member is smaller than said predetermined amount of water absorption and when the amount of deposition of particulate matter in said insulating member is smaller than said predetermined amount of PM deposition, changes according to a change in an engine load of the internal combustion engine, and makes a determination that insulation failure has occurred, in cases where said insulation resistance value does not change according to a change in the engine load of the internal combustion engine.

Fig. 1

Fig. 2

Fig. 3

SHORT TRIP PERIOD

Tehc

Ne

Ne

Tehc

0

TIME

Ws

cwater

cwater0

0

TIME

cpm1

cpm

cpm0

0

TIME

NORMAL

Rehc

INSULATION
FAILURE

Rehc0

t1

t2 t3

t4 t5

TIME

Fig. 4

Fig. 5

START

S101

Tg,A/F,Ga →
CALCULATE kwater1

S102

Tehc →
CALCULATE kwater2

S103

CALCULATE cwater
cwater(i)=cwater(i-1)+kwater1*a-kwater2

S104

cwater ≦ Ws?

NO

S106

cwater=Ws

YES

S105

cwater ≧ 0?

NO

YES

S107

cwater=cwater

S108

cwater=0

RETURN

Fig. 6

A/F

kwater1

SMALL

LARGE

Tg

Fig. 7

kwater2

100°C

Tehc

Fig. 8

START

S201

Tw,A/F,Ga→
CALCULATE kpm1

S202

IS PM REMOVAL PROCESSING
EXECUTION IN EXECUTION?

YES

NO

S203

Tehc→
CALCULATEkpm2

S204

kpm2=0

S205

CALCULATE cpm
cpm(i)=cpm(i−1)+kpm1*b−kpm2

S206

cpm≧0?

YES

NO

S207

cpm=cpm

S208

cpm=0

RETURN

Fig. 9

Fig. 10

Fig. 11

START

S301
READ IN cwater

S302
READ IN cpm

S303
READ IN Rehc

S304
cwater < cwater0?
NO
YES

S305
cpm < cpm0?
NO
YES

B

S308
Rehc > Rehc0?
NO
YES

A

S306
Rehc ≦ Rehc0?
NO
YES

D

C

S307
INSULATION FAILURE HAS OCCURRED

S309
EHC IS NORMAL

RETURN

Fig. 12

Fig. 13

(B)

S317

Rehc > Rehc0?

YES

NO

(E)   (C)

S318

SUSPEND
DETERMINATION

S319

IS PM REMOVAL
PROCESSING EXECUTION
CONDITION SATISFIED?

NO

YES   S320

PERFORM
PM REMOVAL PROCESSING

S321

READ IN cpm

S322

cpm < cpm0?

NO

YES

S323

STOP EXECUTION
OF PM REMOVAL
PROCESSING

S324

READ IN Rehc

S325

Rehc > Rehc0?

NO

YES   S326

DETERMINE THAT CAUSE OF
REDUCTION OF INSULATION
RESISTANCE VALUE IS PM

(D)   (C)

Fig. 14

START

S401

READ IN Tehc

S402

Tehc→
CALCULATE Rehc0

S403

SET PREDETERMINED
RESISTANCE VALUE TO Rehc0

RETURN

Fig. 15

Fig. 16

START

COLD STARTED? — S501

YES

NO

ELAPSED △ts? — S502

YES

NO

READ IN Tehc — S401

Tehc→
CALCULATE Rehc0 — S402

SET PREDETERMINED
RESISTANCE VALUE
TO Rehc0 — S403

SET PREDETERMINED
RESISTANCE VALUE
TO Rehc0_base — S503

RETURN

Fig. 17

Fig. 18

## INTERNATIONAL SEARCH REPORT

| | International application No. |
|---|---|
| | PCT/JP2011/079528 |

A. CLASSIFICATION OF SUBJECT MATTER
*F01N3/20*(2006.01)i

According to International Patent Classification (IPC) or to both national classification and IPC

B. FIELDS SEARCHED

Minimum documentation searched (classification system followed by classification symbols)
F01N3/02-3/38, B01J35/02

Documentation searched other than minimum documentation to the extent that such documents are included in the fields searched

| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | WO 2011/114451 A1 (Toyota Motor Corp.), 22 September 2011 (22.09.2011), (Family: none) | 1-6 |
| A | WO 2011/114482 A1 (Toyota Motor Corp.), 22 September 2011 (22.09.2011), (Family: none) | 1-6 |
| A | JP 2010-275917 A (Honda Motor Co., Ltd.), 09 December 2010 (09.12.2010), (Family: none) | 1-6 |

☐ Further documents are listed in the continuation of Box C.   ☐ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 06 March, 2012 (06.03.12) | 19 March, 2012 (19.03.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011114451 A
- JP 2010127268 A
- JP 2007304068 A
- JP 2010275917 A
- JP 2009144577 A